(19) Europäisches Patentamt
European Patent Office
Office européen des brevets

(11) **EP 2 332 229 B1**

## (12) EUROPÄISCHE PATENTSCHRIFT

(45) Veröffentlichungstag und Bekanntmachung des Hinweises auf die Patenterteilung:
**23.05.2018 Patentblatt 2018/21**

(21) Anmeldenummer: **09778783.2**

(22) Anmeldetag: **30.09.2009**

(51) Int Cl.:
*H02J 3/38* *(2006.01)*      *G01R 31/42* *(2006.01)*
*G01R 31/02* *(2006.01)*      *G01R 31/34* *(2006.01)*
*F03D 17/00* *(2016.01)*

(86) Internationale Anmeldenummer:
**PCT/EP2009/007028**

(87) Internationale Veröffentlichungsnummer:
**WO 2010/037537 (08.04.2010 Gazette 2010/14)**

(54) **WINDENERGIEANLAGENPRÜFEINRICHTUNG**

WIND ENERGY PLANT TESTING DEVICE

DISPOSITIF D'ESSAI D'INSTALLATION AÉROGÉNÉRATRICE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **30.09.2008 DE 102008049629**

(43) Veröffentlichungstag der Anmeldung:
**15.06.2011 Patentblatt 2011/24**

(73) Patentinhaber: **Senvion GmbH**
**22297 Hamburg (DE)**

(72) Erfinder: **LETAS, Heinz-Hermann**
**23701 Süsel (DE)**

(74) Vertreter: **Glawe, Delfs, Moll**
**Partnerschaft mbB**
**von Patent- und Rechtsanwälten**
**Postfach 13 03 91**
**20103 Hamburg (DE)**

(56) Entgegenhaltungen:
**EP-A1- 1 876 460      US-A- 5 886 429**
**US-B1- 6 285 169      US-B1- 6 490 143**
**US-B1- 7 218 122**

**Beschreibung**

Die Erfindung betrifft eine Prüfeinrichtung für Windenergieanlagen. Sie weist einen Ausgang und einen Eingang auf, wobei an den Ausgang die Windenergieanlage angeschlossen ist, und wobei an den Eingang ein Netz anschließbar ist und eine Schalteinrichtung zum Zuschalten einer elektrischen Störkomponente in Bezug auf einen Netzparameter vorgesehen ist.

Mit zunehmender Verbreitung von Windenergieanlagen müssen diese verschärfte Anforderungen in Bezug auf ihr Verhalten gegenüber dem Netz erfüllen. Dies gilt insbesondere für solche Windenergieanlagen, die zum Anschluss an ein Mittelspannungsnetz vorgesehen sind. Die zu erfüllenden Netzanschlussbedingungen werden als "Grid-Codes" der jeweiligen Netzbetreiber bezeichnet. Zu diesen Anforderungen gehört bspw. das Verhalten der Windenergieanlagen gegenüber einem Spannungssprung in der Netzspannung. Diese auch als "Voltage Ride Through" bezeichnete Anforderung besagt, dass Windenergieanlagen beim Vorliegen eines Spannungsfehlers im Netz nicht sofort trennen sollen, sondern zumindest für eine bestimmte Zeit (üblich sind etwa 150 ms) am Netz verbleiben und dann entweder nach Wiederkehr der Netzspannung möglichst schnell wieder elektrische Leistung in das Netz einspeisen sollen, oder sich während der Dauer des Netzfehlers durch Einspeisen von Blindleistung an der Stützung des Netzes, insbesondere in Bezug auf die Netzspannung, beteiligen.

Um diese geforderte Eigenschaft der Windenergieanlagen in Bezug auf die Erfüllung der Anforderungen der Netzbetreiber nachzuweisen, sind Prüfeinrichtungen vorgesehen. Dies beruht auf der Erkenntnis, dass entsprechende Messungen am echten öffentlichen Netz nicht wirklich praktikabel sind. Mit Hilfe der Prüfeinrichtungen werden definiert entsprechende Spannungsfehler simuliert, und das Verhalten der Windenergieanlage kann überprüft werden. Derartige Einrichtungen zur Spannungsprüfung von Windenergieanlagen sind bekannt. So wird der Störfall einer Netzunterspannung simuliert durch Zuschalten von Drosseln.

Aus der EP 1 876 460 A1 ist eine Prüfeinrichtung bekannt, welche zwischen eine zu prüfende Windenergieanlage und dem Netz zu schalten ist. Sie weist einen integrierten Transformator und mehrere matrixweise verschaltete Impedanzen auf, die über Schalter in den Stromkreis eingeschleift werden können. Mit der Einrichtung können verschiedene Fehler, wie ein- oder mehrphasige Kurzschlüsse zwischen Phasen oder zu Masse simuliert werden. Dabei kann die Dauer und die Tiefe eines Spannungseinbruchs verstellt werden, jedoch nicht völlig unabhängig voneinander.

Ferner ist aus der US 5 886 429 A eine Testeinrichtung vorzugsweise für einphasig betriebene Verbraucher bekannt, bei der mittels eines galvanisch getrennten Transformators mittels eines Schleifers auf die Sekundärseite oder mittels mehrerer Abgriffe Spannungssprünge bzw. -einsenkungen erzeugt werden können. Die zu schaltende Leistung fließt hierbei über Halbleiterschalter, so dass sich dieses Gerät nicht zum Schalten sehr großer Leistungen eignet, wie es für Windenergieanlagen erforderlich ist.

Aus der US 6 285 169 B1 ist ein verbessertes Gerät zum Testen mittels Spannungssprüngen bekannt. Es weist einen Spartransformator mit mehreren Abgriffen auf, womit sowohl Unterspannungen wie auch Überspannungen erzeugbar sind.

Aus der US 7 218 122 B1 ist ein Testgerät insbesondere für dreiphasige Spannungssysteme bekannt, welches eine Kombination von Netzspannung einerseits und Zusatzspannungen, die mittels eines Transformators generiert sind, andererseits vorsieht. Aufwendige Schalteinrichtungen sind erforderlich, um diese Spannungsüberlagerung zu bewirken. Die Vielzahl der dazu erforderlichen Schalteinrichtungen sorgt für eine hohe Komplexität.

Der vorliegenden Erfindung liegt die Aufgabe zugrunde, eine Prüfeinrichtung der eingangs genannten Art dahingehend zu verbessern, dass sie freier einstellbar ist zum Prüfen auch auf andere Netzfehler als Kurzschlüsse.

Die erfindungsgemäße Lösung liegt in den Merkmalen des unabhängigen Anspruchs. Vorteilhafte Weiterbildungen sind Gegenstand der abhängigen Ansprüche.

Bei einer Windenergieanlagenprüfeinrichtung zum definierten Erzeugen von Netzfehlern mit einem Ausgang, an dem eine zu prüfende Windenergieanlage anschließbar ist, und einem Eingang zum Anschluss eines Netzes, wobei eine Schalteinrichtung zum Zuschalten einer elektrischen Störkomponente in Bezug auf einen Netzparameter vorgesehen ist, ist erfindungsgemäß vorgesehen, dass ein Spartransformator für die elektrische Störkomponente verwendet ist, und zwar kombiniert mit einer zusätzlichen Schwenkwicklung (32') zu einem Spar-Schwenktransformator, wobei das ungestörte Netz an einen Primärwicklungsanschluss angelegt ist und an einem Sekundärwicklungsanschluss ein in Bezug auf den Netzparameter gestörtes Netz ausgegeben wird.

Nachfolgend seien zuerst einige verwendete Begriffe erläutert:
Unter einem Netzparameter wird eine elektrische Größe des Netzes verstanden, wie die Spannung, die Frequenz oder die Phase. Typischerweise wird eine Größe herangezogen, die sich im Fall einer Netzstörung in der Regel ändert, insbesondere die Netzspannung oder die Netzphase.

Unter einem gestörten Netz wird ein regelwidriger Zustand des Netzes verstanden, der negative Auswirkungen auf die Netzsicherheit hat und dem mit Abhilfemaßnahmen zu begegnen ist.

Unter einem Spartransformator wird eine Anordnung verstanden, bei welcher die Primärwicklung gleichzeitig auch einen Teil der Sekundärwicklung bildet.

Es ist also keine galvanische Trennung zwischen der Primär- und Sekundärwicklung vorhanden. Aus vorstehender Definition folgt, dass die Sekundärwicklung diejenige ist, welche eine größere Windungsanzahl aufweist, nämlich die Anzahl der Windungen der Primärwicklung und eines zusätzlichen Wicklungsteils; die Primärwicklung bildet umgekehrt einen Teil der Sekundärwicklung und weist daher auch nur einen Bruchteil der Windungszahlen der Sekundärwicklung auf. Vereinfacht gesagt ist die Sekundärwicklung diejenige mit der größeren Windungszahl.

Unter einen Anschluss der Primärwicklung wird derjenige Anschluss verstanden, der zusammen mit einem gemeinsamen Fußpunkt ein Anschlusspaar für die Primärwicklung bildet.

Unter einem Sekundärwicklungsanschluss wird der Anschluss verstanden, der zusammen mit dem gemeinsamen Fußpunkt ein zweites Anschlusspaar für die Sekundärwicklung bildet.

Die Erfindung beruht auf der Erkenntnis, dass mit der Verwendung von nur wenigen herkömmlichen Komponenten der elektrischen Energietechnik, nämlich Schaltern, Transformatoren und ggf. Drosseln, eine Prüfeinrichtung auf einfache Weise realisiert werden kann, die auch in Bezug auf Spannungsspitzen bzw. auftretende Phasensprünge verwendet werden kann. Ein an sich bekannter Spartransformator wird in der erfindungsgemäßen Prüfeinrichtung so verwendet, dass er auch zur Erzeugung höherer Spannung dienen kann. Durch diesen verblüffend einfachen Kunstgriff wird erreicht, dass auch Spannungsspitzen zur Prüfung erzeugt werden können. Damit kann auf einfache Weise unter Benutzung herkömmlicher Komponenten das Prüfprogramm für die Windenergieanlagen ausgedehnt werden.

Es sei angemerkt, dass die Verwendung von Spartransformatoren für Prüfeinrichtungen bereits vorgeschlagen wurde. Jedoch wurden sie nur zur Erzeugung von niedrigeren Spannungen verwendet. Die Erfindung hat erkannt, dass durch geeignete Beschaltung der Spartransformator auch so betrieben werden kann, dass er als elektrische Störkomponente zur Erzeugung einer Spannungsspitze dienen kann.

Der erfindungsgemäß vorgesehene Spartransformator bietet weiter den Vorteil, dass er mit einer Schwenkspule kombiniert sein kann (kombinierter Spar-Schwenktransformator). Durch diese Kombination wird erreicht, dass zusätzlich eine Phasenverschiebung erreicht wird. Damit können auf einfache Weise auch Netzstörungen in Bezug auf die Phase kombiniert werden. Es sei angemerkt, dass durch die Auslegung der Wicklungsverhältnisse im Spartransformator auch erreicht werden kann, dass sich keine Spannungsänderung ergibt, sondern dass nur die Phase verschwenkt wird. Vorteilhafter ist dabei eine Anordnung, bei der die zusätzliche Schwenkspule für die Phase schaltbar angeordnet ist. Damit kann je nach Stellung des Schalters zusätzlich ein Phasensprung als weitere Netzstörung aufgeschaltet werden, oder dies kann gleichzeitig mit einem Spannungssprung erfolgen.

Vorzugsweise ist der Spartransformator so ausgebildet, dass er mehrere Abgriffe für den Sekundärspannungsanschluss aufweist. Damit ist es ermöglicht, verschiedene Höhen für den Spannungssprung zu realisieren. Dementsprechend kann auch vorgesehen sein, dass die Schwenkspule für den Spartransformator mehrere Abgriffe aufweist. Damit können auch verschiedene Phasensprünge realisiert werden.

Vorzugsweise ist ein kombinierter Spar-Schwenktransformator mit wechselweise verschwenkt angeordneten Spulenpaaren in Dreiecksschaltung vorgesehen. Unter "wechselweise verschwenkt" wird hierbei verstanden, dass die von den jeweiligen Spulenpaaren eingeschlossenen elektrischen Winkel verschieden sind. Unter dem elektrischen Winkel wird hierbei der aus den Windungszahlen unter Nutzung des Kosinussatzes bestimmte Winkel verstanden. Die genaue Berechnung ist in der Figurenbeschreibung nachfolgend näher angegeben. Diese bevorzugte Ausführungsform bietet den Vorteil, dass sie sowohl ein Testen auf Überspannung wie auch zusätzlich auf einen Phasensprung mit einer einzigen Komponente ermöglicht, und das sogar allphasig.

Es hat sich gezeigt, dass eine besonders günstige Anordnung so beschaffen ist, dass der Spar-Schwenktransformator für einen Winkel von 53° ausgelegt ist. Das bedeutet, dass die elektrischen Winkel wechselweise 53° bzw. 67° betragen, wodurch sich über drei Phasen hinweg eine Summe von 360° ergibt. Es sei angemerkt, dass durch Veränderung bzw. Anpassung der Windungszahlen auch andere, an sich beliebige Schwenkwinkel erzeugt werden können.

Mit Vorteil ist eine Multischalteinheit für den Schwenktransformator vorgesehen. Diese Multischalteinheit ist so ausgebildet, dass derselbe Spartransformator umgeschaltet werden kann auf eine zweite Anschaltvariante, bei welcher er zur Erzeugung einer Unterspannung dient. Damit kann ein und derselbe Spartransformator dafür genutzt werden, sowohl zur Prüfung auf Spannungsspitzen wie auch Unterspannung herangezogen zu werden. Es kann auch vorgesehen sein, dass der Spartransformator mehrere parallele Transformatoren aufweist, die unabhängig zuschaltbar sind. Die einzelnen Transformatoren können damit für unterschiedliche Funktionen ausgelegt sein, so dass sie je nach Wunsch aktiviert werden können.

Mit Vorteil sind die Schalter der Schalteinrichtung und ggf. der Multischalteinheit als Doppelschalter ausgebildet. Dies bietet den Vorteil einer kurzen Schaltzeit. Falls sehr kurze Schaltzeiten erwünscht sind, so können die Schalter auch als elektronische Schalter ausgeführt sein. Dies bietet den weiteren Vorteil, dass eine hohe Verschleißfestigkeit und damit eine lange Lebensdauer auch bei hohen Schaltzyklen gegeben ist.

Mit einer besonders vorteilhaften Ausführungsform der Erfindung kann vorgesehen sein, dass ein Wechselrichter in der elektrischen Störkomponente vorgesehen ist. Damit können durch entsprechende Ansteuerung des Wechselrichters an sich frei wählbare Netzstörungen aufgeschaltet werden. Ein Transformator ist dann nicht mehr unbedingt erforderlich, und kann ggf. durch den Wechselrichter ersetzt sein.

Die Erfindung wird nachfolgend unter Bezugnahme auf die beigefügte Zeichnung, in der ein vorteilhaftes Ausführungsbeispiel dargestellt ist, näher erläutert. Es zeigen:

Fig. 1      eine schematisierte Ansicht einer Windenergieanlage mit einer Prüfeinrichtung gemäß einer ersten Ausführungsform;

Fig. 2      eine schematisierte Ansicht einer Prüfeinrichtung gemäß einer zweiten Ausführungsform;

Fig. 3      ein Schaltungsbeispiel für eine Prüfeinrichtung gemäß der ersten Ausführungsform;

Fig. 4      ein weiteres Schaltbeispiel für eine Prüfeinrichtung gemäß der ersten Ausführungsform;

Fig. 5      ein anderes Schaltbeispiel für eine Prüfeinrichtung gemäß der zweiten Ausführungsform;

Fig. 6 a, b      Schaltbeispiele für die Prüfeinrichtung der ersten Ausführungsform mit einer Multischalteinheit;

Fig. 7      einen Transformator für das zweite Schaltbeispiel; und

Fig. 8      eine Verschaltung des Transformators gemäß Fig. 7.

Prüfeinrichtungen gemäß der vorliegenden Erfindung dienen zur Prüfung des Verhaltens einer Windenergieanlage 1 am Stromnetz. Als Stromnetz kann ein tatsächlich vorhandenes öffentliches Stromnetz 9 herangezogen werden, oder es kann auf eine oder mehrere das Stromnetz simulierende Spannungsquellen 9' zurückgegriffen werden.

Die Prüfeinrichtung, welche in ihrer Gesamtheit die Bezugsziffer 2 bzw. 2' trägt, ist zwischen der Windenergieanlage 1 und dem Stromnetz 9 bzw. der als Ersatz fungierenden Spannungsquelle 9' geschaltet. Dabei ist der Transformator 11, der meist als ein Mittelspannungstransformator der Windenergieanlage 1 ausgeführt ist, im Regelfall zwischen die Prüfeinrichtung 2 und die Windenergieanlage 1 geschaltet. Das gilt jedenfalls bei einer Windenergieanlage 1 mit doppelt gespeistem Asynchrongenerator. Bei anderen Ausführungen kann ggf. die Prüfeinrichtung zwischen der Windenergieanlage 1 und dem Transformator 11 geschaltet sein.

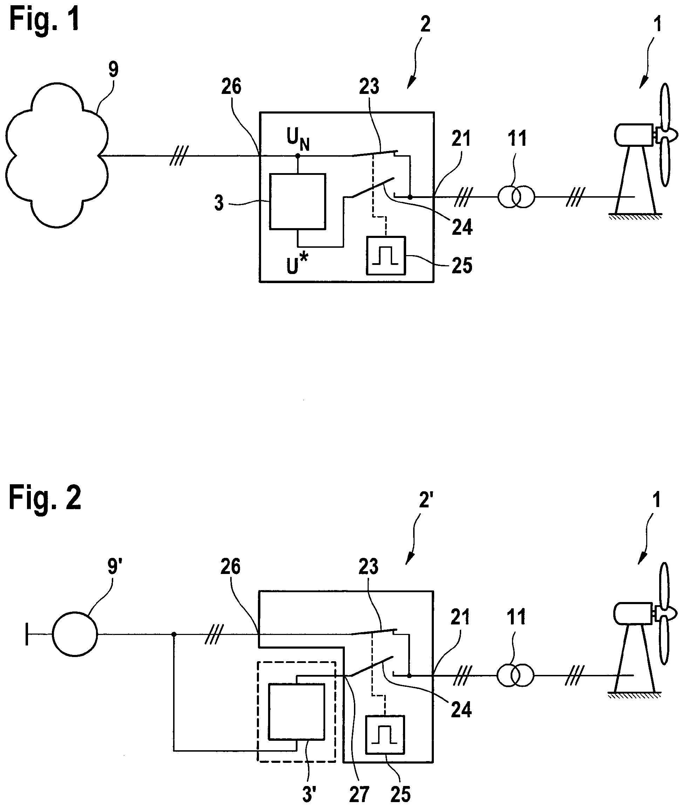

Der Grundaufbau sei am Beispiel der in Fig. 1 dargestellten ersten Ausführungsform erläutert. Die Windenergieanlage 1 ist über einen Transformator 11 an einen Ausgang 21 der Prüfeinrichtung 2 angeschlossen. Mit dem Ausgang 21 verbunden sind ein erster Schalter 23 und ein zweiter Schalter 24. Die beiden Schalter sind gesteuert durch ein Schaltmodul 25. In Abhängigkeit von einem von dem Schaltmodul 25 abgegebenen Betätigungssignal sind die beiden Schalter 23, 24 in einer ersten Stellung, in welcher der erste Schalter 23 geschlossen und der zweite Schalter 24 geöffnet ist (in Fig. 1 dargestellt), oder in einer zweiten Stellung, in welcher der erste Schalter 23 geöffnet und der zweite Schalter 24 geschlossen ist. In der ersten Stellung ist der Ausgang 21 direkt verbunden mit einem Eingang 26, an dem das Stromnetz 9 angeschlossen sein kann. Diese Schalterstellung steht für den Normalbetrieb der Windenergieanlage 1 an einem ungestörten Stromnetz 9. In der zweiten Schalterstellung ist der Ausgang 21 verbunden mit einer elektrischen Störkomponente 3. Sie ist dazu ausgebildet, aus der von dem öffentlichen Netz 9 bereitgestellten Spannung $U_N$ eine gestörte Spannung $U^*$ zu erzeugen, welche im Störungsfall auf die Windenergieanlage 1 geschaltet wird. Die gestörte Spannung $U^*$ weicht von der Spannung $U_N$ des Stromnetzes 9 ab, insbesondere kann sie höher zum Simulieren eines Überspannungsfalls liegen. Durch kontrolliertes Betätigen der beiden Schalter 23, 24 kann der Zeitpunkt und die Zeitdauer der (simulierten) Netzspannungsstörung bestimmt werden, mit der die Windenergieanlage 1 beaufschlagt wird. Durch Verstellen der Spannung der Störkomponente 3 kann die Schwere der Spannungsstörung kontrolliert werden. Diese Ausführungsform der Prüfeinrichtung bietet den Vorteil, dass sie unmittelbar einen Test der Windenergieanlage 1 am öffentlichen Stromnetz 9 ermöglicht, und mit geringem Zusatzaufwand die zum Testen erforderliche gestörte Spannung autark mittels der elektrischen Störkomponente 3 erzeugt werden kann. Diese Ausführungsform bietet damit Vorteile bezüglich einfacherer Handhabung. Anhand ihr soll die Erfindung beispielhaft näher erläutert werden.

Eine zweite in Fig. 2 dargestellte alternative Ausführungsform unterscheidet sich von der in Fig. 1 dargestellten im Wesentlichen dadurch, dass die Störkomponente 3' als gesondertes Modul ausgebildet ist. Dazu ist ein zweiter Eingang 27 aus der Prüfeinrichtung 2' herausgeführt ist, der zum Anschluss an das öffentliche Netz vorgesehen ist, welches hier durch eine zur Simulation vorgesehene Spannungsquelle 9' ersetzt ist. Die Prüfeinrichtung 2' unterscheidet sich von der Prüfeinrichtung 2 im Wesentlichen dadurch, dass die elektrische Störkomponente 3' nicht mehr die Prüfeinrichtung 2' integriert ist, sondern modularisiert ist. Dies bietet die Möglichkeit, verschiedene elektrische Störkomponenten 3' vorzusehen, die je nach Anwendungsfall als Modul an die Prüfeinrichtung 2' angesteckt werden.

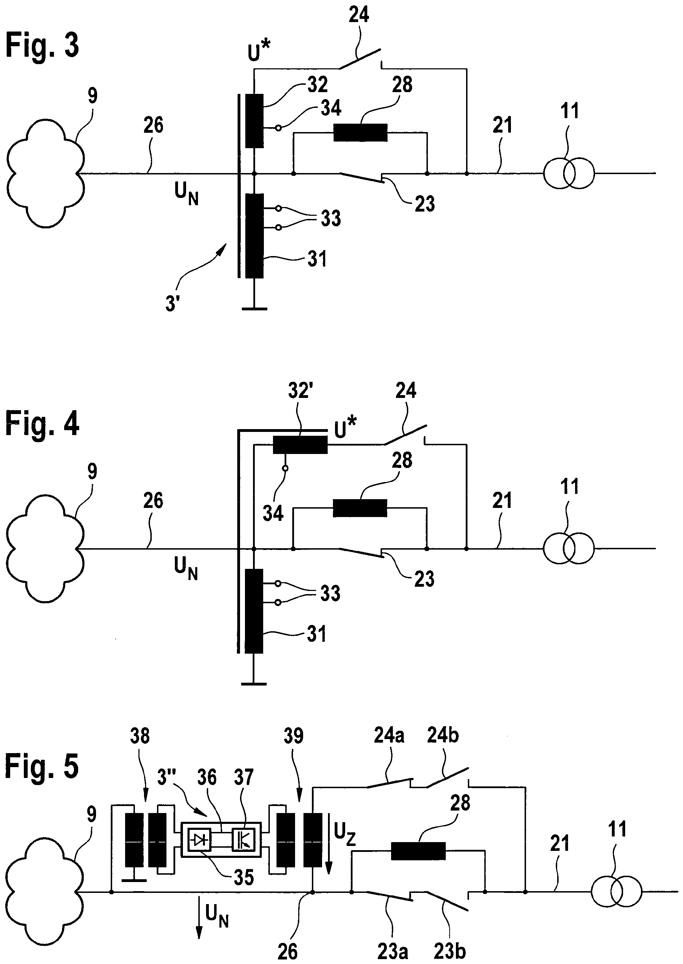

In Fig. 3 und 4 sind zwei verschiedene Schaltungsbeispiele für die Ausführung der Prüfeinrichtung 2 dargestellt. Aus Gründen der Vereinfachung ist das Schaltmodul 25 für die beiden Schalter 23, 24 nicht dargestellt. An den Ausgang 21 ist jeweils über den Transformator 11 eine Windenergieanlage (nicht dargestellt) angeschlossen. An den Eingang 26 ist das öffentliche Stromnetz 9 angeschlossen. Man erkennt wiederum den ersten Schalter 23, welcher im Normalbetrieb die Windenergieanlage über den Transformator 11 direkt mit dem Stromnetz 9 verbindet. Man erkennt weiter den zweiten Schalter 24, welcher bei Öffnen des ersten Schalters 23 eine gestörte Spannung auf die Windenergieanlage 1 zu den Transformator 11 aufschaltet. Zusätzlich ist eine Drossel 28 vorgesehen, welche parallel zum ersten Schalter 23 geschaltet ist. Sie fungiert als Umschalthilfe zur Überbrückung von Schaltpausen, welche beim Umschalten der beiden Schalter 23, 24 unweigerlich entstehen. Denn zum Vermeiden eines Kurzschlusses zwischen der Normalspannung und der gestörten Spannung muss die Abfolge der Schaltpunkte der beiden Schalter 23, 24 so gewählt sein, dass sie sich nicht überschneiden, sondern dass sich eine zumindest minimale Pause ergibt, während der beide Schalter geöffnet sind. Um auch während dieser Schaltpause definierte Zustände am Ausgang 21 zu schaffen, ist die Drossel 28 vorgesehen. Es sei angemerkt, dass es sich bei der Drossel 28 um eine einfache Induktivität (wie dargestellt) handeln kann, oder es kann stattdessen ein Transformator mit einer kurzgeschlossenen Sekundärseite verwendet werden. Letzteres bietet den Vorteil einer besseren Toleranz gegenüber Stromstößen, welche ein Mehrfaches des Nennstroms betragen können und erhebliche thermische und auch magnetische Belastungen hervorrufen. Insbesondere magnetische Überlastung kann ein als Drossel geschalteter Transformator besser verkraften als eine einfache Drossel.

Die elektrische Störkomponente 3 besteht bei dieser Schaltungsanordnung aus einem Spartransformator mit einer Primärwicklung 31 und einer Sekundärwicklung 32. Die Primärwicklung 31 ist mit einem Anschluss (Fußpunkt) an einen Sternpunkt angeschlossen, der geerdet sein kann, und an dem anderen Anschluss ist der Eingang 26 zum Anschluss des (ungestörten) öffentlichen Stromnetzes 9 angeschlossen. An den Anschluss der Sekundärwicklung 32 wiederum ist der Schalter 24 angeschlossen. Die Wirkweise des Spartransformators als elektrische Störkomponente 3 ist wie folgt. Im Normalbetrieb ist der Schalter 24 offen und der Schalter 23 geschlossen. Die am Anschluss für die Primärwicklung 31 angelegte Spannung des öffentlichen Netzes 9 ist direkt über den Transformator 11 mit der Windenergieanlage 1 verbunden. Werden die Schalter 23, 24 betätigt, so öffnet zuerst der Schalter 23, wodurch der Strom über die Drossel 28 fließt (es ergibt sich hierbei in der Regel ein Phasensprung), bis dann schließlich der Schalter 24 schließt. Die vom Netz 9 an den Eingang 26 angelegte Spannung wird nun nicht mehr 1:1 durchgeleitet, sondern wird von dem Spartransformator im Verhältnis der Wicklungszahlen zwischen Primärwicklung 31 und Sekundärwicklung 32 erhöht, so dass eine Überspannung schließlich über den Transformator 11 an die Windenergieanlage 1 angelegt wird. Die Rückschaltung erfolgt in umgekehrter Reihenfolge, in dem zunächst Schalter 24 geöffnet wird und nach Ablauf der Schaltpause Schalter 23 geschlossen wird. Die Windenergieanlage 1 kann damit auf ihre Überspannungsfestigkeit geprüft werden.

In Fig. 4 ist eine weitere Schaltungsanordnung dargestellt. Sie unterscheidet sich von der in Fig. 3 dargestellten im Wesentlichen dadurch, dass der Spartransformator für die elektrische Störkomponente 3' als Spar-Schwenktransformator ausgebildet ist. Dies bedeutet, dass die Sekundärwicklung 32' zusätzlich als Schwenkwicklung ausgeführt ist, d. h. sie dreht die Phase der daran angeschlossenen Spannung. Die Erfindung hat erkannt, dass in der Praxis Spannungssprünge im Netz sich in aller Regel nicht nur auf die Höhe der Spannung auswirken, sondern auch auf deren Phase. Mit dieser Schaltungsanordnung bietet die Erfindung den Vorteil, dass dies durch die besondere Ausführung des Spar-Schwenktransformators mit der integrierten Schwenkwicklung 32' berücksichtigt werden kann. Das Anwendungsspektrum der so ausgerüsteten erfindungsgemäßen Prüfeinrichtung vergrößert sich dadurch.

Es sei angemerkt, dass vorzugsweise die Sekundärwicklung 32 sowie 32' mit Zwischenanzapfungen 34 versehen sein kann. Indem der zweite Schalter 24 an eine dieser Anzapfungen 34 angeschlossen wird, kann der Grad der Überspannung sowie der Grad des Schwenkwinkels gewählt werden. Entsprechendes gilt für die Primärwicklung 31, die ebenfalls mit mehreren Anzapfungen 33 versehen sein kann, mit welcher dann wahlweise der Eingang 26 verbunden sein kann.

In Fig. 5 ist eine alternative Schaltungsvariante dargestellt, bei welcher als elektrische Störkomponente statt des Schwenktransformators ein Umrichter 3" vorgesehen ist. Er umfasst einen aktiven Gleichrichter 35, einen Zwischenkreis 36 und einen Wechselrichter 37. Der Gleichrichter 35 kann an das öffentliche Netz 9 angeschlossen sein, kann aber auch auf andere Weise mit elektrischer Energie versorgt sein. Der Wechselrichter 37 erzeugt eine Zusatzspannung $U_Z$, welche auf die Spannung $U_N$ des öffentlichen Netzes 9 addiert wird und am zweiten Schalter 24 anliegt. Die Anschaltung des Gleichrichters 35 und des Wechselrichters 37 erfolgt über Koppeltransformatoren 38, 39 zur Abtrennung des Mittelspannungspotentials. Werden, wie vorstehend beschrieben, der erste und der zweite Schalter 23, 24 betätigt, so wird mit Schließen des zweiten Schalters 24 eine überhöhte Spannung über den Transformator 11 an die Windenergieanlage 1 angelegt. Durch entsprechende Ansteuerung des Wechselrichters 37 kann die Polarität der Spannung $U_Z$ auch umgedreht werden, so dass eine Unterspannung im Schalter 24 anliegt. Damit kann auch das Verhalten der Windenergieanlage bei Unterspannung getestet werden. Die Schalter 23, 24 sind als Doppelschalter 23 a, b und 24 a, b ausgeführt. Damit können sehr kurze Schaltzeiten realisiert werden, um so auch kurzzeitige Spannungsspitzen bzw. -einbrüche (Transienten) nachzubilden. Diese Doppelschalter können auch bei den Ausführungsformen gemäß Fig. 3 und 4 vorgesehen sein. Es sei angemerkt, dass mit einer schnellen Regelung am Wechselrichter 37 die Beaufschlagung mit der Störkomponente auch ohne Schalter 23, 24 direkt vom Wechselrichter 37 aus gesteuert werden kann.

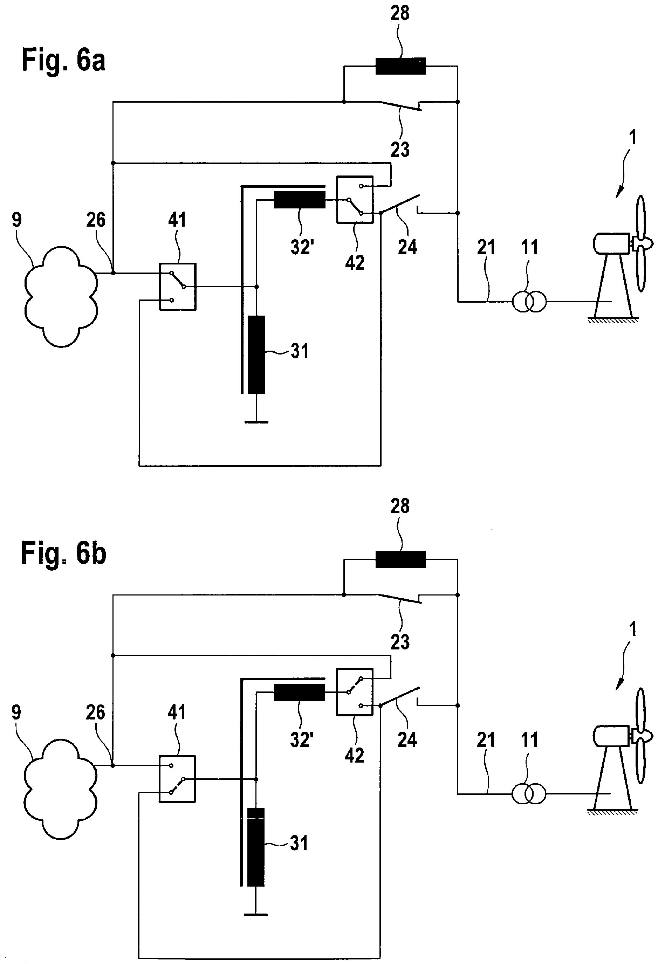

In Fig. 6 ist eine weitere Schaltungsanordnung dargestellt, welche wahlweise zur Erzeugung einer Über- oder Unterspannung herangezogen werden kann. Sie basiert auf der Schaltungsvariante gemäß Fig. 4. Zusätzlich ist eine Multischalteinheit 4 vorgesehen. Sie umfasst zwei Wechselschalter 41, 42, die wahlweise den Eingang 26 mit dem Anschluss der Primärwicklung 31 oder der Sekundärwicklung 32 bzw. den zweiten Schalter 24 mit dem Anschluss der Sekundärwicklung 32 oder der Primärwicklung 31 verbinden. Befindet sich die Multischalteinheit 4 in ihrer Ruhestellung, wie sie in Fig. 6a dargestellt ist, so ergibt sich eine Schaltanordnung entsprechend der in Fig. 4. Mit Betätigen des ersten und zweiten Schalters 23, 24 wird damit die Windenergieanlage 1 mit einer Überspannung beaufschlagt. Befindet sich hingegen die Umschaltanlage in der zweiten, in Fig. 6b dargestellten Stellung, so bildet sich eine Schaltanordnung, bei welcher der Spar-Schwenktransformator nunmehr zur Spannungsuntersetzung geschaltet ist, und an den zweiten Schalter 24 eine gegenüber der Spannung am Eingang 26 niedrigere Spannung angelegt ist. Durch Betätigen der Schalter 23, 24 wird die Windenergieanlage 1 also mit einer Unterspannung beaufschlagt. Mit dieser Umschaltanlage ist die erfindungsgemäße Prüfeinrichtung in Kombination mit dem erfindungsgemäß vorgesehenen Spartransformator auf verblüffend einfache Weise in der Lage, sowohl Unter- wie auch Überspannungsprüfung durchzuführen.

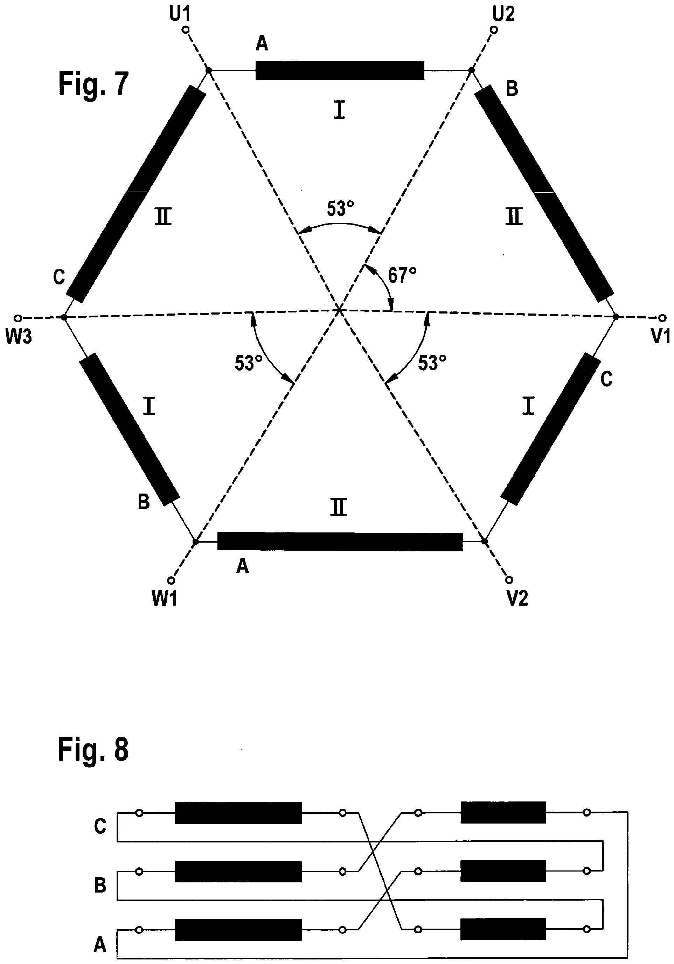

Ein technisches Ausführungsbeispiel für einen entsprechenden Spar-/Schwenktransformator für Drehstromanwendungen ist in Fig. 7 dargestellt. Man erkennt sechs Wicklungen, die als wechselweise angeordnete Wicklungen eines ersten Typs I und eines zweiten Typs II ausgeführt sind. Der Transformator sei dafür berechnet, dass die an den Ausgangsklemmen U1, V1, W1 anliegende Ausgangsspannung von bspw. 20kV genauso groß sei wie die an den Eingangsklemmen U2, V2, W2 anliegende Eingangsspannung von 20kV. Im dargestellten Ausführungsbeispiel ist der Trafo berechnet für einen Schwenkwinkel von 53°. Hieraus kann unter Verwendung des "Kosinussatzes" mit der Strangspannung als Schenkel eines gleichschenkligen Dreiecks die Wicklungsspannung der Wicklung des ersten Typs I bestimmt werden gemäß der Formel:

$$U_I = \frac{20kV}{\sqrt{3} \times \sqrt{2 \times (1 - \cos 53°)}}$$

woraus sich ein Wert von 10,3kV ergibt. Entsprechend ergibt sich für die Wicklungsspannung der Wicklungen des zweiten Typs II

$$U_{II} = \frac{20kV}{\sqrt{3} \times \sqrt{2 \times (1 - \cos 67°)}}$$

woraus sich ein Wert von 12,75kV ergibt.

Die Schenkel des Trafos sind jeweils gebildet durch zwei einander gegenüberliegende Wicklungen, also in Fig. 7 bspw. durch die oben gelegene Wicklung des Typs I und unten gelegene Wicklung des Typs II für den ersten Schenkel, usw. Das Verhältnis der Spannungen $U_I$ und $U_{II}$ steht damit direkt für das Verhältnis der Wicklungszahlen von Primär- und Sekundärwicklung des Spar-/Schwenktransformators.

Ein Beispiel für die Anschlussverschaltung der einzelnen Wicklungen des Spar-/Schwenktransformators ist in Fig. 8 dargestellt. Die sich an den Eingangs- und Ausgangsanschlüssen einstellenden Spannungen sind hierbei gleich hoch, jedoch um einen Phasenwinkel von 53° gegeneinander verschwenkt. Es sei angemerkt, dass Aus- und Eingang miteinander vertauscht werden können, wodurch der Phasenwinkel umgedreht werden kann, sich also zu -53° ergibt. Durch Anpassung der Windungszahlen sind beliebige Schwenkwinkel und auch Übersetzungsverhältnisse der Spannungen möglich. Sind eine oder mehrere Anzapfungen an den Wicklungen vorgesehen, so können mit nur einem Trafo unterschiedliche Schwenkwinkel und ggf. auch Spannungsübersetzungen erreicht werden.

**Patentansprüche**

1. Windenergieanlagenprüfeinrichtung zum definierten Erzeugen von Netzfehlern mit einem Ausgang (21), an dem eine zu prüfende Windenergieanlage (1) anschließbar ist, und einem Eingang (26) zum Anschluss eines Netzes (9), wobei eine Schalteinrichtung (23, 24) zum Zuschalten einer elektrischen Störkomponente (3) in Bezug auf einen Netzparameter vorgesehen ist,
   **dadurch gekennzeichnet, dass**
   ein Spartransformator für die elektrische Störkomponente (3) verwendet ist, und zwar kombiniert mit einer zusätzlichen Schwenkwicklung (32') zu einem Spar-Schwenktransformator, wobei das ungestörte Netz an einem Primärwicklungsanschluss (31) angelegt ist und an einem Sekundärwicklungsanschluss (32) ein in Bezug auf den Netzparameter gestörtes Netz ausgegeben wird.

2. Windenergieanlagenprüfeinrichtung nach Anspruch 1,
   **dadurch gekennzeichnet, dass**
   die Schwenkwicklung (32') schaltbar ausgeführt ist.

**3.** Windenergieanlagenprüfeinrichtung nach einem der Ansprüche 1 oder 2,
**dadurch gekennzeichnet, dass**
die Primär- und/oder Sekundärwicklung (31, 32) mit mehreren Abgriffen (33, 34) versehen ist.

**4.** Windenergieanlagenprüfeinrichtung nach einem der Ansprüche 1 bis 3,
**dadurch gekennzeichnet, dass**
die Schwenkwicklung (32') mit mehreren Abgriffen (34) versehen ist.

**5.** Windenergieanlagenprüfeinrichtung nach einem der vorhergehenden Ansprüche,
**dadurch gekennzeichnet, dass**
ein Spar-/Schwenktransformator mit integrierter Schwenkwicklung (32') vorgesehen ist.

**6.** Windenergieanlagenprüfeinrichtung nach einem der Ansprüche 1 bis 5,
**dadurch gekennzeichnet, dass**
die Schwenkwicklung so ausgelegt ist, dass sich ein elektrischer Winkel zwischen den Phasen von 50° bis 60°, vorzugsweise 53° ergibt.

**7.** Windenergieanlagenprüfeinrichtung nach einem der vorhergehenden Ansprüche,
**dadurch gekennzeichnet, dass**
die Schalteinrichtung (23, 24) Doppelschalter umfasst, die zur Erzeugung kurzer Schaltzeiten in Serie geschaltet sind.

**8.** Windenergieanlagenprüfeinrichtung nach einem der vorhergehenden Ansprüche,
**dadurch gekennzeichnet, dass**
die Schalteinrichtung elektronische Schalter umfasst.

**9.** Windenergieanlagenprüfeinrichtung nach einem der vorhergehenden Ansprüche,
**dadurch gekennzeichnet, dass**
eine Multischalteinheit (4) vorgesehen ist, welche die elektrische Störkomponente (3) umschaltet zwischen einer Überspannungs- und Unterspannungsbetriebsart.

**10.** Windenergieanlagenprüfeinrichtung nach einem der vorhergehenden Ansprüche,
**dadurch gekennzeichnet, dass**
die elektrische Störkomponente einen Wechselrichter (3") umfasst.

**11.** Windenergieanlagenprüfeinrichtung nach einem der vorhergehenden Ansprüchen,
**dadurch gekennzeichnet dass**,
der Spartransformator aus mehrere, parallelen Transformatoren besteht, die einzeln aktivierbar sind.

**12.** Verfahren zum Testen einer Windenergieanlage mit den Schritten Verbinden eines Spartrafos, der kombiniert ist mit einer zusätzlichen Schwenkwicklung zu einem Spar-Schwenktransformator, in Reihe und/oder parallel zur Verbindung zwischen Verteilnetz und Windenergieanlage mit einem ersten Übersetzungsverhältnis, insbesondere von 1:1, zeitweises Umschalten des Spartrafos auf ein anderes Übersetzungsverhältnis mit einer höheren Sekundärspannung und/oder verschwenkter Phase für eine vordefinierte Zeit, Zurückschalten des Spartrafos auf das erste Übersetzungsverhältnis.

**13.** Verfahren nach Anspruch 12,
**dadurch gekennzeichnet, dass**
Schritt zwei mit verschiedenen Übersetzungsverhältnissen und/oder Trafos durchgeführt wird.

**14.** Verfahren nach Anspruch 12 oder 13,
**dadurch gekennzeichnet, dass**
Schritt zwei mit verschiedenen Schwenkwinkeln durchgeführt wird.

**Claims**

**1.** Wind energy installation test device for defined production of grid system faults having an output (21), to which a wind energy installation (1) to be tested can be connected, and having an input (26) for connection of a grid system (9), wherein a switching device (23, 24) is provided for connection of an electrical disturbance component (3) relating to a grid system parameter,
**characterized in that**
an autotransformer is used for the electrical disturbance component (3), and specifically combined with an additional phase-displacement winding (32') to form an autotransformer/phase-displacement transformer, with the sound grid system being connected to a primary winding connection (31) and with a grid system which has been disturbed with respect to the grid system parameter being output at a secondary winding connection (32).

**2.** Wind energy installation test device according to Claim 1,
**characterized in that**
the phase-displacement winding (32') is designed to be switchable.

**3.** Wind energy installation test device according to one of Claims 1 and 2
**characterized in that**
the primary and/or the secondary winding (31, 32) are/is provided with a plurality of taps (33, 34).

**4.** Wind energy installation test device according to one of Claims 1 to 3,
**characterized in that**
the phase-displacement winding (32') is provided with a plurality of taps (34).

5. Wind energy installation test device according to one of the preceding claims,
**characterized in that**
an autotransformer/phase-displacement transformer having an integrated phase-displacement winding (32') is provided.

6. Wind energy installation test device according to one of Claims 1 to 5,
**characterized in that**
the phase-displacement winding is designed to produce an electrical angle between the phases of 50° to 60°, preferably 53°.

7. Wind energy installation test device according to one of the preceding claims,
**characterized in that**
the switching device (23, 24) comprises double switches which are connected in series in order to produce short switching times.

8. Wind energy installation test device according to one of the preceding claims,
**characterized in that**
the switching device comprises electronic switches.

9. Wind energy installation test device according to one of the preceding claims,
**characterized in that**
a multi-switching unit (4) is provided, and switches the electrical disturbance component (3) between an overvoltage and an undervoltage operating mode.

10. Wind energy installation test device according to one of the preceding claims,
**characterized in that**
the electrical disturbance component comprises an inverter (3").

11. Wind energy installation test device according to one of the preceding claims,
**characterized in that**
the autotransformer consists of a plurality of parallel transformers which can be activated individually.

12. Method for testing a wind energy installation, having the steps of connection of an autotransformer, which is combined with an additional phase-displacement winding to form an autotransformer/phase-displacement transformer, in series and/or in parallel with the connection between the distribution grid system and the wind energy installation, with a first transformation ratio, in particular of 1:1, time switching of the autotransformer to a different transformation ratio with a higher secondary voltage and/or displaced phase for a predefined time, and switching back the autotransformer to the first transformation ratio.

13. Method according to Claim 12,
**characterized in that**
step two is carried out with different transformation ratios and/or transformers.

14. Method according to Claim 12 or 13,
**characterized in that**
step two is carried out with different phase-displacement angles.

**Revendications**

1. Dispositif de vérification d'éolienne permettant de produire des défauts définis de réseau et présentant une sortie (21) à laquelle une éolienne (1) à vérifier peut être raccordée et une entrée (26) permettant le raccordement à un réseau (9),
un dispositif de commutation (23, 24) permettant de brancher un composant électrique (3) perturbant un paramètre du réseau étant prévu,
**caractérisé en ce que**
un transformateur abaisseur de tension est utilisé pour le composant électrique perturbateur (3) et est combiné avec un bobinage supplémentaire de déphasage (32') pour former un transformateur déphaseur et abaisseur de tension,
**en ce que** le réseau non perturbé est raccordé à une borne (31) du bobinage primaire et
**en ce qu'**un réseau dont le paramètre est perturbé est délivré sur une borne (32) du bobinage secondaire.

2. Dispositif de vérification d'éolienne selon la revendication 1, **caractérisé en ce que** le bobinage de déphasage (32') est commutable.

3. Dispositif de vérification d'éolienne selon l'une des revendications 1 ou 2, **caractérisé en ce que** le bobinage primaire et/ou le bobinage secondaire (31, 32) sont dotés de plusieurs bornes de prélèvement (33, 34).

4. Dispositif de vérification d'éolienne selon l'une des revendications 1 à 3, **caractérisé en ce que** le bobinage de déphasage (32') est doté de plusieurs bornes de prélèvement (34).

5. Dispositif de vérification d'éolienne selon l'une des revendications précédentes, **caractérisé en ce qu'**un transformateur abaisseur de tension et déphaseur à bobinage déphaseur (32') intégré est prévu.

**6.** Dispositif de vérification d'éolienne selon l'une des revendications 1 à 5, **caractérisé en ce que** le bobinage déphaseur est conçu de manière à obtenir contre les phases un angle électrique de 50° à 60° et de préférence de 53°.

**7.** Dispositif de vérification d'éolienne selon l'une des revendications précédentes, **caractérisé en ce que** le dispositif de commutation (23, 24) comporte des commutateurs doubles qui sont raccordés en série pour former des commutations de courte durée.

**8.** Dispositif de vérification d'éolienne selon l'une des revendications précédentes, **caractérisé en ce que** le dispositif de commutation comporte des commutateurs électroniques.

**9.** Dispositif de vérification d'éolienne selon l'une des revendications précédentes, **caractérisé en ce qu'**il présente une unité (4) de multi-commutation qui fait basculer les composants électriques perturbateurs (3) entre un mode de fonctionnement en surtension et un mode de fonctionnement en sous-tension.

**10.** Dispositif de vérification d'éolienne selon l'une des revendications précédentes, **caractérisé en ce que** le composant électrique perturbateur comporte un redresseur (3").

**11.** Dispositif de vérification d'éolienne selon l'une des revendications précédentes, **caractérisé en ce que** le transformateur abaisseur de tension est constitué de plusieurs transformateurs parallèles qui peuvent être activés individuellement.

**12.** Procédé de test d'une éolienne, le procédé comportant les étapes qui consistent à raccorder un transformateur abaisseur de tension combiné à un bobinage supplémentaire de déphasage pour former un transformateur abaisseur de tension et déphaseur, en série et/ou en parallèle à la liaison entre le réseau de distribution et l'éolienne dans un premier rapport de transformation, en particulier de 1:1, commuter pendant une partie du temps le transformateur abaisseur de tension à un autre rapport de transformation dont la tension secondaire est plus élevée et/ou la phase est tournée pendant une durée prédéfinie et ramener le transformateur abaisseur de tension au premier rapport de transformation.

**13.** Procédé selon la revendication 12, **caractérisé en ce que** l'étape deux est exécutée à différents rapports de transformation et/ou avec différents transformateurs.

**14.** Procédé selon les revendications 12 ou 13, **caractérisé en ce que** l'étape deux est réalisée à différents angles de déphasage.

**Fig. 1**

**Fig. 2**

# Fig. 3

# Fig. 4

# Fig. 5

## Fig. 6a

28

23

9

26

41

32'

42

24

31

1

21

11

## Fig. 6b

28

23

9

26

41

32'

42

24

31

1

21

11

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1876460 A1
- US 5886429 A
- US 6285169 B1
- US 7218122 B1